# EUROPÄISCHE PATENTSCHRIFT

(11) **EP 3 022 325 B1**
(45) Veröffentlichungstag und Bekanntmachung des Hinweises auf die Patenterteilung: **04.10.2017**
(21) Anmeldenummer: 14741282.9
(22) Anmeldetag: 17.07.2014
(51) Int. Cl.: C22B 9/04, C01B 33/03

(54) **VORRICHTUNG UND VERFAHREN ZUM SEQUENTIELLEN SCHMELZEN UND RAFFINIEREN IN EINEM KONTINUIERLICHEN VERFAHREN**
APPARATUS AND METHOD FOR SEQUENTIAL MELTING AND REFINING IN A CONTINUOUS PROCESS
PROCEDE ET DISPOSITIF DE FONTE ET D'AFFINAGE SÉQUENTIELS DANS UN PROCESSUS CONTINU

(30) Priorität: 18.07.2013 DE 102013107685
(43) Veröffentlichungstag der Anmeldung: 25.05.2016
(73) Patentinhaber: ALD Vacuum Technologies GmbH, 63457 Hanau (DE)
(72) Erfinder: FRANZ, Henrik, 63579 Freigericht (DE); NIEBLING, Arno, 63589 Linsengericht (DE); BIEBRICHER, Ulrich, 61194 Niddatal (DE)
(74) Vertreter: Fuchs Patentanwälte Partnerschaft mbB
(86) Internationale Anmeldenummer: PCT/EP2014/065429
(87) Internationale Veröffentlichungsnummer: WO 2015/007861

(56) Entgegenhaltungen:
- EP-A1- 0 796 820
- DE-A1- 2 118 894
- DE-B- 1 291 760
- US-A- 4 027 722
- US-A- 5 503 655

## Beschreibung

Diese Erfindung betrifft eine Vorrichtung und ein mit der Vorrichtung durchführbares Verfahren zum sequentiellen Schmelzen und Raffinieren von Materialien. Die in dem Verfahren behandelten Materialien werden durch eine oder mehrere Wärmequellen in einen flüssigen Aggregatzustand überführt oder sind bereits vor der Behandlung in einem solchen Zustand. Das Verfahren ist besonders geeignet, Metalle, Halbmetalle und Keramiken zu behandeln, beispielsweise um Legierungen herzustellen und/oder die Materialien zu raffinieren.

Aus dem Stand der Technik sind zahlreiche Verfahren bekannt, mit denen Materialien erwärmt werden können. Ein solches Verfahren ist das Elektronenstrahlverfahren, bei dem ein Elektronenstrahl auf ein Material gerichtet wird, um dort gezielt Wärme zu generieren. Dieses Verfahren ist besonders flexibel, weil eine bestimmte Materialportion gezielt auf sehr hohe Temperaturen erhitzt werden kann. Wenn größere Materialportionen wärmebehandelt werden sollen, kann der Elektronenstrahl über das zu erwärmende Material gescannt werden.

Das Elektronenstrahlschmelzverfahren kann nur unter Vakuum durchgeführt werden. Durch die inhärente Verfahrensführung im Vakuum ergibt sich der Vorteil, dass eventuell im Material vorhandene Verunreinigungen entfernt werden können. Das Material wird raffiniert. Andererseits kann aufgrund des Vakuums beim Elektronenstrahlverfahren auch die Materialzusammensetzung durch Verdampfen von flüchtigen Bestandteilen geändert werden, was zum Beispiel bei der Raffination vorteilhaft sein kann. Dieses Verdampfen von flüchtigen Bestandteilen tritt naturgemäß besonders stark in Materialmischungen auf, die inhomogen sind, beispielsweise Gemenge aus Metallspänen und Zusätzen, die noch nicht aufgeschmolzen sind. Das Verdampfen kann erwünscht sein oder ein Problem darstellen, wenn die ursprüngliche Zusammensetzung erhalten bleiben soll. Dieses Problem tritt selbstverständlich auch bei anderen Schmelz- und Raffinationsverfahren auf, die unter Vakuum bei Temperaturen > 500 °C durchgeführt werden.

Ein anderes aus dem Stand der Technik bekanntes Verfahren ist das Plasmaschmelzen, bei dem das Material bei Drücken erhitzt wird, die deutlich oberhalb 1 mbar liegen, insbesondere oberhalb 100 mbar liegen. Das Plasmaschmelzen eignet sich gut zum Aufschmelzen von vielen Materialien.

Es gibt zahlreiche Verfahren zum Schmelzen und Raffinieren von Materialien bei reduziertem Druck bzw. unter Vakuumbedingungen. Beispielhaft können die Verfahren in drei Kategorien eingeteilt werden: die Hochvakuumverfahren sind Verfahren, die in einem Druckbereich zwischen 10⁻⁷ mbar und 10⁻² mbar durchgeführt werden. Die Vakuumverfahren sind Verfahren, die in einem Druckbereich zwischen 10⁻² mbar und 100 mbar durchgeführt werden. Die Niederdruckverfahren werden in einem Druckbereich zwischen 100 mbar und 1 atm durchgeführt.

Wenn eine Schmelze nacheinander bei verschiedenen Drücken behandelt werden muss und die in den Verfahren verwendeten Erwärmungsverfahren nur oder nur bevorzugt bzw. effizient im jeweiligen Druckbereich arbeiten, so ist es heute notwendig, diese Behandlung in einem Batchprozess durchzuführen. Beispielsweise muss das Material zwischendurch aus einem Tiegel entnommen und in einen anderen überführt werden. Eine kontinuierliche Behandlung mit verschiedenen Verfahren ist oft wünschenswert. Bei der Raffination eines Materials kann es zum Beispiel notwendig sein, eine oder mehrere Verunreinigungen in einem Druckbereich >100 mbar zu entfernen, wenn diese Verunreinigung mit einem reaktiven Gas wie etwa Sauerstoff reagieren muss, um flüchtig zu werden. In einem zweiten Schritt kann es notwendig sein, ein tiefes Vakuum anzulegen, um flüchtige Verunreinigungen zu entfernen. Es liegt auf der Hand, dass so eine sequentielle Behandlung nicht ohne weiteres in einem kontinuierlichen Verfahren durchgeführt werden kann. Insbesondere ist der apparative Aufwand sehr hoch, weil die Niveaus der Schmelze abhängig vom vorherrschenden Druck unterschiedlich wären. Je nach Dichte der Schmelze können schnell einige Meter Niveauunterschied vorkommen. Eine entsprechende Anlage würde sehr viel Platz benötigen und wäre somit unwirtschaftlich.

DE 1 291 760 A beschreibt ein Verfahren, bei dem zuerst mittels Elektronenstrahlbeheizung im Vakuum eine Grundcharge eines Metalls erwärmt wird. Flüchtige Legierungsbestandteile werden danach zugesetzt und mit Plasmastrahl beheizt. Die Behandlung des Metalls findet allerdings in einem einzigen Behandlungsgefäß statt, wo die entsprechende Schmelze nacheinander mit unterschiedlichen Methoden bei unterschiedlichen Drücken beheizt wird. Ein kontinuierlicher Betrieb ist nur mit einer sehr komplexen Anlage möglich. Ferner erfordert das dort beschriebene Verfahren eine sequentielle Zugabe von Legierungsbestandteilen, was gemäß der vorliegenden Erfindung bevorzugt nicht stattfindet. Ferner werden Druckunterschiede nicht zum Transport des Materials nutzbar gemacht, denn der Transferkanal mündet nicht in den zweiten Prozessbehälter, sondern endet oberhalb des Niveaus der Schmelze im zweiten Behälter. Im Übrigen erfolgt der Transport der Schmelze durch den Transferkanal nicht durch wandernde elektromagnetische Felder.

DE 2 118 894 C2 lehrt zwar einen Transport der Schmelze mittels elektromagnetischer Pumpe. Es ist aber keine Verlangsamung oder ein Stoppen des Flusses offenbart.

In US 5 503 655 A wird keine elektromagnetische Beeinflussung des Materialflusses erwähnt. Insbesondere ist nicht von einem Verlangsamen oder Stoppen des Flusses die Rede.

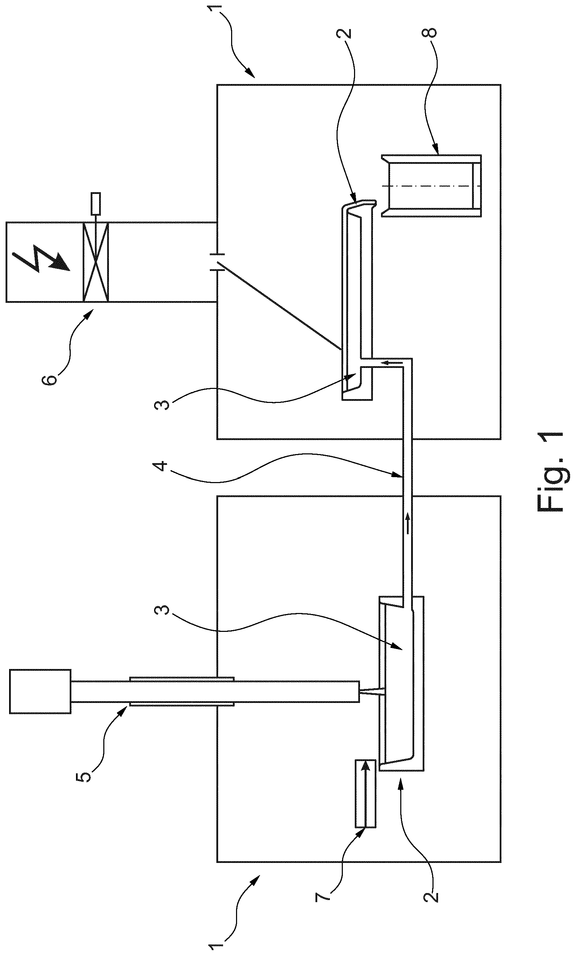

In US 4 027 722 A wird ein sehr simples System beschrieben, um eine Metallschmelze mit einem Elektronenstrahlverfahren zu erhitzen. Eine elektromagnetische Beeinflussung der Fließgeschwindigkeit findet nicht statt. Stattdessen wird der Druckunterschied zwischen den Kammern genutzt, um die Schmelze durch ein Rohr 26 zu fördern (Fig.1).Es besteht also ein Bedarf, die Vorteile von Hochvakuumverfahren, Vakuumverfahren und Niederdruckverfahren in einem kontinuierlichen Verfahren kombinieren zu können, ohne den apparativen Aufwand zu sehr zu erhöhen.

Diese Erfindung stellt so ein Verfahren und eine entsprechende Vorrichtung bereit.

Das Verfahren umfasst folgende Schritte
- ein flüssiges Material wird bei verschiedenen Drücken in verschiedenen Behandlungskammern erwärmt und/oder raffiniert, wobei die Abgrenzung der Druckniveaus durch das flüssige Material selbst erfolgt,
- das flüssige Material wird von einer ersten Behandlungskammer in eine andere zweite Behandlungskammer überführt, wobei der Transfer des Materials durch Druckunterschiede in Kombination mit elektromagnetischer Beeinflussung der Fließgeschwindigkeit zwischen den Behandlungskammern erzielt wird, und
- die in den Behandlungskammern eingesetzten Wärmequellen arbeiten unabhängig voneinander,
dadurch gekennzeichnet, dass die elektromagnetische Beeinflussung unter Verwendung von Mitteln erfolgt, die ein wanderndes elektromagnetisches Feld erzeugen, und die Beeinflussung eine Verlangsamung und/oder ein Stoppen des Flusses des flüssigen Materials umfasst,
und der Druck in der zweiten Behandlungskammer geringer ist als in der ersten Behandlungskammer.

Dass die mindestens zwei Wärmequellen unabhängig voneinander arbeiten, bedeutet vorzugsweise, dass es sich dabei um unterschiedliche Wärmequellen handelt oder um gleiche Wärmequellen, die bei unterschiedlichen Drücken arbeiten. Vorzugsweise ist eine Wärmequelle ein Plasmabrenner und eine andere Wärmequelle eine Elektronenstrahlkanone ist, oder beide Wärmequellen sind Elektronenstrahlkanonen bzw. beide Wärmequellen sind Plasmabrenner, die bei unterschiedlichen Drücken arbeiten.

Die elektromagnetische Beeinflussung der Fließgeschwindigkeit findet unter Verwendung von Mitteln statt, die ein wanderndes elektromagnetisches Feld erzeugen können. Über diese Mittel kann der Fluss des flüssigen Materials veranlasst, beschleunigt, verlangsamt oder sogar gestoppt werden. Durch Verlangsamung oder Stoppen des Materialflusses können durch den Druckunterschied bedingte Niveauunterschiede der Schmelzen in den verschiedenen Behandlungskammern vermindert und/oder verhindert werden. Bevorzugte Mittel sind eine oder mehrere Spulen, insbesondere segmentierte Spulen bzw. mehrere sequentielle entlang eines Transferkanals angeordnete Spulen. Das erfindungsgemäße Verfahren zur sequentiellen Wärmebehandlung dient insbesondere zur Herstellung von Legierungen und/oder zur Raffination. Es kann einen oder mehrere der folgenden Schritte umfassen:
- Einbringen des zu behandelnden Materials in die erste Behandlungskammer,
- Erwärmen und/oder Raffinieren des Materials, so dass das Material einen flüssigen Zustand annimmt oder behält bzw. raffiniert wird,
- Überführen des flüssigen Materials in die zweite Behandlungskammer,
- Erwärmen und/oder Raffinieren des flüssigen Materials in der zweiten Behandlungskammer.

In einer Behandlungskammer, insbesondere der ersten, erfolgt die Behandlung des Materials vorzugsweise bei einem Druck von >10 mbar, weiter bevorzugt > 100 mbar, mehr bevorzugt >300 mbar, weiter bevorzugt >500 mbar und besonders bevorzugt bei >800 mbar. In der anderen Behandlungskammer, insbesondere der zweiten, ist der Druck vorzugsweise geringer, insbesondere beträgt der Druck dort nur bis zu 10 mbar, vorzugsweise bis zu 1 mbar, weiter bevorzugt bis zu 0,1 mbar und besonders bevorzugt bis zu 0,01 mbar.

Das Überführen des flüssigen Materials von der einen Behandlungskammer in die andere Behandlungskammer erfolgt vorzugsweise mittels eines Transferkanals, der ein kontinuierliches Fließen des flüssigen Materials erlaubt. Das Verfahren kann also kontinuierlich betrieben werden. Selbstverständlich ist auch ein halbkontinuierlicher oder Batch-Betrieb möglich, was aus wirtschaftlichen Gründen weniger bevorzugt ist.

Der Transferkanal erlaubt vorzugsweise den Transfer des flüssigen Materials von der ersten in die zweite Behandlungskammer. Der Transfer des flüssigen Materials erfolgt unter anderem aufgrund von Druckunterschieden zwischen den Behandlungskammern. Das flüssige Material fließt entlang der Druckgradienten und/oder vermittelt durch die elektromagnetische Beeinflussung des flüssigen Materials von der ersten in die zweite Behandlungskammer. Der Druck in der zweiten Behandlungskammer ist geringer als in der ersten Behandlungskammer, so dass das flüssige Material, mittels eines vorhandenen Druckgradienten vorzugsweise in Kombination mit vorhandenen Höhenunterschieden gezielt gefördert wird. Dabei wird das Verfahren vorzugsweise so durchgeführt bzw. die Vorrichtung so ausgestaltet, dass der Transferkanal im Betrieb komplett mit Material gefüllt ist. Dadurch wird gewährleistet, dass in den Behandlungskammern die unterschiedlichen Drücke aufrechterhalten werden.

Die Behandlungskammern sind im Übrigen vorzugsweise so ausgestaltet, dass sie gegenüber der Umgebung hermetisch abdichtbar sind, so dass der Prozessdruck entsprechend eingestellt werden kann. Dies trifft insbesondere für die Behandlungskammer zu, in der niedrigerer Druck herrscht. Die Behandlungskammern können entweder komplett separate Behandlungskammern sein oder durch Aufteilung einer großen Kammer in zwei Behandlungskammern, etwa durch Einbringen eines Trennelements, wie einer Trennwand, in die große Kammer erfolgen.

In den Behandlungskammern kann ein Prozessbehälter, insbesondere ein Tiegel oder eine Wanne, angeordnet sein, in dem sich das Material während des Verfahrens befindet. Der Prozessbehälter kann aber auch als Teil der Behandlungskammer ausgestaltet sein oder mit ihr identisch sein. Vorzugsweise enthält je eine Behandlungskammer einen Prozessbehälter. In einer alternativen Ausführungsform erstreckt sich ein Prozessbehälter von einer Behandlungskammer in die andere, wobei der Transferkanal eine Öffnung in dem Trennelement sein kann.

Zum Einbringen des zu behandelnden Materials in die erste Behandlungskammer weist die erfindungsgemäße Vorrichtung vorzugsweise eine Zufuhreinrichtung auf, die ein kontinuierliches Einbringen des Materials in die erste Behandlungskammer ermöglicht. So eine Zufuhreinrichtung kann beispielsweise eine Förderrinne sein.

Das behandelte Material kann nach Durchführung des erfindungsgemäßen Verfahrens aus der zweiten Behandlungskammer entnommen werden. Zu diesem Zweck umfasst die Vorrichtung vorzugsweise eine Entnahmeeinrichtung, die eine Entnahme des Materials ermöglicht. Wenn die zweite Behandlungskammer bei einem Prozessdruck betrieben wird, der unterhalb des Umgebungsdruckes liegt, so ist es vorteilhaft, die Entnahme des behandelten Materials so zu gestalten, dass der Unterdruck in der Kammer aufrechterhalten wird. Dies kann vorzugsweise dadurch geschehen, dass die Entnahmeeinrichtung als ein Abfluss ausgestaltet ist. In einer alternativen Ausführungsform befindet sich ein Sammelbehälter für das behandelte Material in der Behandlungskammer mit niedrigerem Druck, so dass der Behälter bis zu seiner Entnahme in der Behandlungskammer verbleiben kann.

Der Transferkanal stellt eine Verbindung zwischen den beiden Behandlungskammern her. Er ist vorzugsweise beheizt, etwa mit einer Induktionsheizung oder einem Brenner, damit das flüssige Material nicht erstarrt. In Ausführungsformen ohne Beheizung des Transferkanals sollten die Behandlungskammern sehr nah beieinander aufgestellt werden, wenn Material mit hohem Schmelzpunkt und/oder ungünstigem Viskositäts-Temperatur-Profil eingesetzt wird. Der Transferkanal hat vorteilhafterweise zwei Öffnungen, eine proximale und eine distale. Durch die proximale Öffnung kann das flüssige Material aus der ersten Behandlungskammer in den Transferkanal eintreten, durch die distale Öffnung kann es in die zweite Behandlungskammer wieder austreten.

Die proximale Öffnung des Transferkanals kann so angeordnet sein, dass das flüssige Material aus der ersten Behandlungskammer beziehungsweise aus dem ersten Prozessbehälter in den Transferkanal hinabfällt. Die erste Behandlungskammer bzw. der erste Prozessbehälter muss also nicht mit dem Transferkanal verbunden sein. Die proximale Öffnung des Transferkanals ist vorzugsweise im unteren Bereich der ersten Behandlungskammer angeordnet oder, wenn die Behandlungskammer nicht auch der Prozessbehälter ist, im unteren Bereich des ersten Prozessbehälters. Dies hat sich als vorteilhaft erwiesen, weil die Zufuhr von zu behandelndem Material am einfachsten von oben stattfinden kann und auch die Beheizung vorzugsweise von oben erfolgt. Im unteren Bereich der ersten Behandlungskammer ist das Material also idealerweise bereits in einem hinreichend flüssigen Zustand, um durch den Transferkanal hindurch zu fließen. Die distale Öffnung mündet in die zweite Behandlungskammer, insbesondere in deren unteren Bereich, oder, wenn die Behandlungskammer nicht auch der Prozessbehälter ist, in dessen unteren Bereich. Sie mündet insbesondere in einen Bereich der zweiten Behandlungskammer, der unterhalb des Niveaus der Schmelze in dieser Behandlungskammer liegt.

Das Niveau des flüssigen Materials ist in einer Behandlungskammer vorzugsweise höher als in der anderen Behandlungskammer. Dieser Niveauunterschied stellt sich insbesondere aufgrund der unterschiedlichen Prozessdrücke in den beiden Kammern ein. Aus diesem Grund ist die zweite Behandlungskammer bzw. der zweite Prozessbehälter vorzugsweise höher angeordnet als die erste Behandlungskammer bzw. der erste Prozessbehälter. Allerdings kann dieser Höhenunterschied wesentlich kleiner ausfallen als im Stand der Technik, da erfindungsgemäß gegengesteuert werden kann.

Die Schmelz und Raffinationsprozesse in der ersten Behandlungskammer erfolgen vorzugsweise unter Verwendung eines Niederdruckverfahrens, insbesondere durch ein Plasmaschmelzverfahren.

In der ersten Behandlungskammer wird das Material vorzugsweise auf Temperaturen von 1000 bis 3000°C, weiter bevorzugt 1200 bis 2500°C, besonders bevorzugt 1400 bis 2000°C erhitzt. Optional können reaktive Gase (z.B. Sauerstoff, Wasserstoff, Stickstoff) oder inerte Gase (z.B. Argon, Helium) eingeleitet werden. Zu diesem Zweck umfasst die erfindungsgemäße Vorrichtung vorzugsweise einen Gaseinlass, insbesondere um Gase in die erste Behandlungskammer kontrolliert einleiten zu können. Die Behandlungskammer, in der ein niedrigerer Druck herrscht, umfasst solche Gaseinlässe vorzugsweise nicht.

Die Schmelz und Raffinationsprozesse in der zweiten Behandlungskammer erfolgen vorzugsweise unter Verwendung von Hochvakuumverfahren, oder Vakuumverfahren, insbesondere durch ein Elektronenstrahlverfahren.

In der zweiten Behandlungskammer wird das Material vorzugsweise auf Temperaturen von 1000 bis 4000 °C, weiter bevorzugt 1200 bis 3800 °C, besonders bevorzugt 1400 bis 3500°C erhitzt. Vorzugsweise wird auf die Einleitung eines reaktiven Gases verzichtet oder es werden geringe Gasmengen eingesetzt, die einer Aufrechterhaltung des Betriebsdruckes nicht entgegenstehen.

Das zu behandelnde Material umfasst vorzugsweise Metalle, Halbmetalle, Keramiken oder Mischungen daraus. Das zu behandelnde Material ist vorzugsweise im Wesentlichen metallisch, halbmetallisch und/oder besitzt im flüssigen Zustand eine ausreichende elektrische Leitfähigkeit. Bevorzugte zu behandelnde Materialien sind Titan und Silizium; es können aber auch Stähle, reaktive und refraktäre Metalle oder Verbundmaterialien, die Keramiken umfassen, eingesetzt werden.

Damit das Material vorteilhaft in dem erfindungsgemäßen Verfahren eingesetzt werden kann, weist es vorzugsweise eine Leitfähigkeit im flüssigen Zustand von wenigstens 1*10² S/m auf. Der Schmelzpunkt des zu behandelnden Materials beträgt vorzugsweise >1000°C bei Normaldruck.

Je nach zu behandelndem Material kann das zu schmelzende Material Verunreinigungen enthalten, die unter den unterschiedlichen Bedingungen des Verfahrens entfernt werden. Beispiele für Verunreinigungen, die in dem zu schmelzenden Material enthalten sein können, sind Bor und Phosphor.

In einer besonders bevorzugten Ausführungsform umfasst das zu behandelnde Material Silizium, insbesondere in einem Anteil von mehr als 95% (m/m). Zur Behandlung von Silizium wird dieses in der ersten Behandlungskammer erhitzt, um Verunreinigungen zu entfernen, unter den erfindungsgemäßen Bedingungen lässt sich beispielsweise Bor entfernen; danach wird das Silizium als flüssige Schmelze über den Transferkanal in die zweite Behandlungskammer überführt, wo aufgrund des niedrigen Drucks auch andere Verunreinigungen, wie beispielsweise Phosphor entfernt werden können.

Die ebenfalls erfindungsgemäße Vorrichtung ist zur Durchführung des Verfahrens geeignet. Die Vorrichtung umfasst vorzugsweise
o eine erste Behandlungskammer,
o eine zweite Behandlungskammer und
o einen Transferkanal, der die beiden Kammern miteinander verbindet,
wobei beide Behandlungskammern mit je wenigstens einer Wärmequelle versehen sind. Die Wärmequellen arbeiten vorzugsweise unabhängig voneinander und sind unabhängig voneinander regelbar. Der Transferkanal ist vorzugsweise so angeordnet, dass er von einer in die andere Behandlungskammer ansteigt. Die Vorrichtung umfasst Mittel zur elektromagnetischen Beeinflussung der Fließgeschwindigkeit. Diese Mittel beeinflussen die Fließgeschwindigkeit eines flüssigen, leitfähigen Materials, das sich im Transferkanal befindet. Diese Mittel sind solche, die wandernde elektromagnetische Felder erzeugen können. Dies sind vorzugsweise eine oder mehrere Spulen, insbesondere segmentierte Spulen. Die Mittel sind vorzugsweise um den Transferkanal herum angeordnet. Neben Spulen sind aber auch andere Mittel denkbar, mit denen elektromagnetische Felder generiert werden können, die eine Beeinflussung der Fließgeschwindigkeit im Sinne einer magnetohydrodynamischen Beeinflussung ermöglichen.

Die erste Behandlungskammer weist eine Wärmequelle auf, die ausgewählt ist aus Plasmabrenner und Elektronenstrahlkanone, während die zweite Behandlungskammer eine Elektronenstrahlkanone als Wärmequelle umfasst.

### Figurenbeschreibung

Die in den Figuren dargestellten Ausführungsformen zeigen beispielhafte Ausführungsformen der Erfindung.
**Fig.1** zeigt eine erfindungsgemäße Vorrichtung mit zwei Behandlungskammern 1 und zwei Prozessbehältern 2. Es ist zu erkennen, dass jede Behandlungskammer 1 je einen Prozessbehälter 2 enthält. In den Prozessbehältern befindet sich das zu behandelnde Material 3, das spätestens beim Eintritt in den Transferkanal 4 flüssig sein muss. Es sind zwei Wärmequellen 5 und 6 abgebildet, die unterschiedlich sind. Wärmequelle 5 kann beispielsweise ein Plasmabrenner sein, Wärmequelle 6 kann beispielsweise eine Elektronenstrahlkanone sein. Es ist erkennbar, dass das Niveau des flüssigen Materials in der zweiten Behandlungskammer höher ist als in der ersten. Das flüssige Material muss also im Transferkanal 4 steigen. Dies wird durch einen Druckunterschied verursacht, denn der Plasmabrenner wird in diesem Beispiel im Niederdruckbereich betrieben, während die Elektronenstrahlkanone im Vakuum betrieben wird. Die Pfeile zeigen die Fließrichtung des flüssigen Materials. Das flüssige Material füllt den Transferkanal 4 komplett, so dass die Druckniveaus in beiden Kammern gehalten werden können. Die Zufuhreinrichtung 7 führt neues zu behandelndes Material zu, damit ein kontinuierlicher Prozess möglich ist. Der Behälter 8 sammelt das behandelte Material.

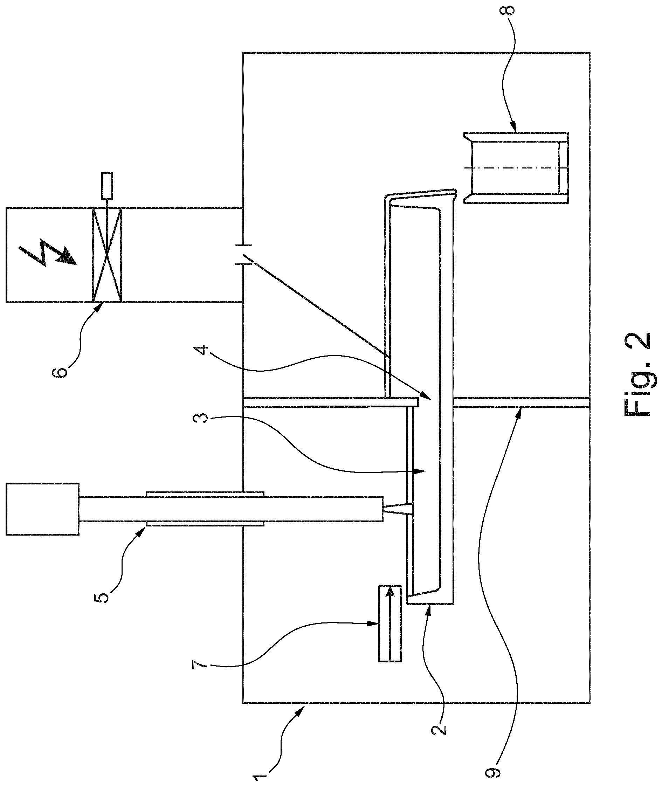

**Fig.2** zeigt eine erfindungsgemäße Vorrichtung mit einer großen Kammer 1, die unter Verwendung einer Trennwand 9 in zwei Behandlungskammern aufgeteilt ist. Es ist nur ein Prozessbehälter 2 vorhanden, der sich über beide Kammern erstreckt. In dem Prozessbehälter befindet sich das zu behandelnde Material 3, das spätestens beim Eintritt in den Transferkanal 4 flüssig sein muss. Der Transferkanal ist hier sehr kurz ausgestaltet. Das hat den Vorteil, dass das flüssige Material beim Übertritt von einer in eine andere Behandlungskammer nur geringfügig abkühlt. Es sind zwei Wärmequellen 5 und 6 abgebildet, die unterschiedlich sind. Wärmequelle 5 kann beispielsweise ein Plasmabrenner sein, Wärmequelle 6 kann beispielsweise eine Elektronenstrahlkanone sein. Es ist erkennbar, dass das Niveau des flüssigen Materials in der zweiten Behandlungskammer höher ist als in der ersten. Dies wird durch einen Druckunterschied verursacht, denn der Plasmabrenner wird in diesem Beispiel im Niederdruckbereich betrieben, während die Elektronenstrahlkanone im Vakuum betrieben wird. Das flüssige Material füllt den Transferkanal 4 komplett, so dass die Druckniveaus in beiden Kammern gehalten werden können. Die Zufuhreinrichtung 7 führt neues zu behandelndes Material zu, damit ein kontinuierlicher Prozess möglich ist. Der Behälter 8 sammelt das behandelte Material.

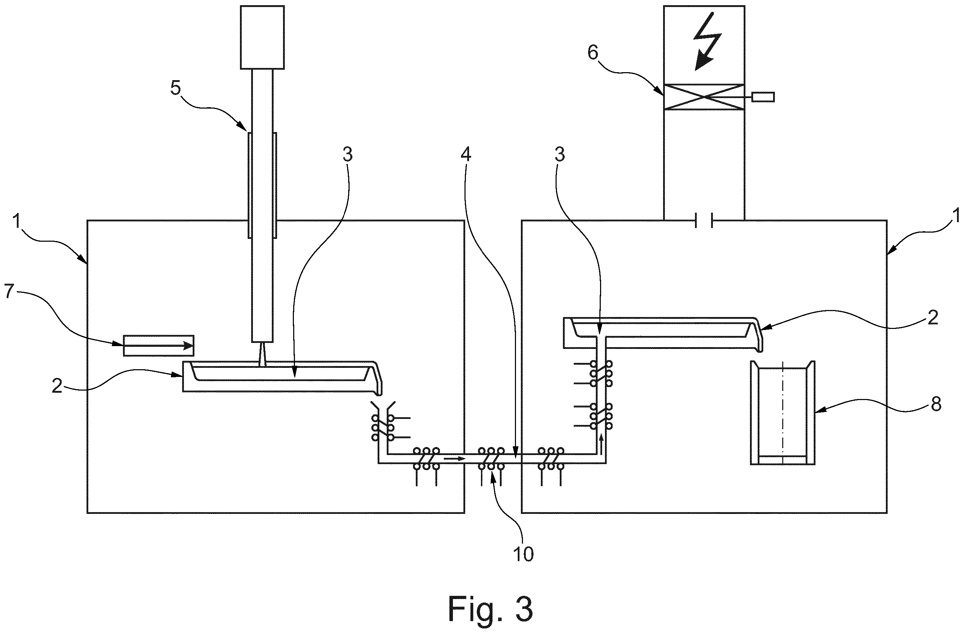

**Fig.3** zeigt eine erfindungsgemäße Vorrichtung mit zwei Behandlungskammern 1 und zwei Prozessbehältern 2. Es ist zu erkennen, dass jede Behandlungskammer 1 je einen Prozessbehälter 2 enthält. In den Prozessbehältern befindet sich das zu behandelnde Material 3, das spätestens beim Eintritt in den Transferkanal 4 flüssig sein muss. Es sind zwei Wärmequellen 5 und 6 abgebildet, die unterschiedlich sind. Wärmequelle 5 kann beispielsweise ein Plasmabrenner sein, Wärmequelle 6 kann beispielsweise eine Elektronenstrahlkanone sein. Es ist erkennbar, dass das Niveau des flüssigen Materials in der zweiten Behandlungskammer höher ist als in der ersten. Das flüssige Material muss also im Transferkanal 4 steigen. Dies wird durch einen Druckunterschied verursacht, denn der Plasmabrenner wird in diesem Beispiel im Niederdruckbereich betrieben, während die Elektronenstrahlkanone im Vakuum betrieben wird. Die Pfeile zeigen die Fließrichtung des flüssigen Materials. Das flüssige Material füllt den Transferkanal 4 komplett, so dass die Druckniveaus in beiden Kammern gehalten werden können. Die Zufuhreinrichtung 7 führt neues zu behandelndes Material zu, damit ein kontinuierlicher Prozess möglich ist. Der Behälter 8 sammelt das behandelte Material. Um die Fließgeschwindigkeit des flüssigen Materials durch den Transferkanal 4 zu steuern, weist die Vorrichtung ein Mittel zur magnetohydrodynamischen Regulierung des Flusses, wie beispielsweise Spulen 10, auf. Die proximale Öffnung des Transferkanals ist hier so angeordnet, dass das flüssige Material aus dem ersten Prozessbehälter in den Transferkanal hinabfällt.

### Bezugszeichenliste

- 1: Behandlungskammer
- 2: Prozessbehälter
- 3: zu behandelndes Material
- 4: Transferkanal
- 5: Wärmequelle A
- 6: Wärmequelle B
- 7: Zufuhreinrichtung
- 8: Sammelbehälter
- 9: Trennwand
- 10: Spule

## Patentansprüche

1. Verfahren zur sequentiellen Behandlung eines Materials, wobei
• ein flüssiges Material 3 bei verschiedenen Drücken in verschiedenen Behandlungskammern 1 erschmolzen und raffiniert wird, wobei die Abgrenzung der Druckniveaus durch das flüssige Material selbst erfolgt, so dass ein kontinuierlicher Prozess möglich ist,
• das flüssige Material von einer ersten Behandlungskammer in eine andere zweite Behandlungskammer überführt wird, wobei der Transfer des Materials durch Druckunterschiede in Kombination mit elektromagnetischer Beeinflussung der Fließgeschwindigkeit zwischen den Behandlungskammern erzielt wird, und
• die in den Behandlungskammern eingesetzten Wärmequellen unabhängig voneinander arbeiten,
**dadurch gekennzeichnet, dass** die elektromagnetische Beeinflussung unter Verwendung von Mitteln erfolgt, die ein wanderndes elektromagnetisches Feld erzeugen, und die Beeinflussung eine Verlangsamung und/oder ein Stoppen des Flusses des flüssigen Materials umfasst,
und der Druck in der zweiten Behandlungskammer geringer ist als in der ersten Behandlungskammer.

2. Verfahren nach Anspruch 1 **dadurch gekennzeichnet, dass** der Transfer der Schmelze von der ersten Behandlungskammer in die zweite in einem Kanal 4 erfolgt, der auch beheizt ausgeführt werden kann.

3. Verfahren nach Anspruch 1 oder 2 umfassend die Schritte:
• Einbringen des zu behandelnden Materials 3 in die erste Behandlungskammer 1,
• Wärmebehandeln des Materials in der ersten Behandlungskammer bei einem Druck von > 10 mbar, so dass das Material einen flüssigen Zustand annimmt oder behält,
• Überführen des flüssigen Materials in die zweite Behandlungskammer,
• Wärmebehandeln des flüssigen Materials in der zweiten Behandlungskammer bei einem Druck von bis zu 10 mbar.
**dadurch gekennzeichnet, dass** das Überführen des flüssigen Materials von der ersten Behandlungskammer in die zweite Behandlungskammer mittels eines Transferkanals 4 durchgeführt wird, der die beiden Behandlungskammern verbindet und ein kontinuierliches Fließen des flüssigen Materials erlaubt.

4. Verfahren nach wenigstens einem der vorhergehenden Ansprüche, wobei die Wärmequelle in der zweiten Behandlungskammer eine Elektronenstrahlkanone ist.

5. Verfahren nach wenigstens einem der vorhergehenden Ansprüche, wobei das zu behandelnde Material wenigstens ein Metall, Halbmetall oder eine Keramik umfasst.

6. Verfahren nach wenigstens einem der vorhergehenden Ansprüche, wobei das zu behandelnde Material Silizium umfasst.

7. Verfahren nach wenigstens einem der vorhergehenden Ansprüche, wobei die elektromagnetische Beeinflussung der Fließgeschwindigkeit im Transferkanal 4 mit Hilfe wenigstens einer um den Transferkanal angeordneten Spule 10 erfolgt.

8. Verfahren nach wenigstens einem der vorhergehenden Ansprüche, wobei die Schmelze nach erfolgter Behandlung flüssig einer weiteren Behandlung zugeführt wird oder flüssig einer separaten Vorrichtung zur Erstarrung zugeführt wird und dort erstarrt.

9. Verfahren nach wenigstens einem der vorhergehenden Ansprüche, wobei die Erstarrung der Schmelze nach der Behandlung als Blockabzug aus einem induktiv beheizten, wassergekühlten Kupfertiegel erfolgt.

10. Verfahren nach wenigstens einem der vorhergehenden Ansprüche, wobei eine Wärmequelle ein Plasmabrenner ist und eine andere Wärmequelle eine Elektronenstrahlkanone ist, oder beide Wärmequellen Elektronenstrahlkanonen sind, oder beide Wärmequellen Plasmabrenner sind, die bei unterschiedlichen Drücken arbeiten.

11. Verfahren nach wenigstens einem der vorhergehenden Ansprüche, wobei das Material in der ersten Behandlungskammer auf Temperaturen von 1000°C bis 3000 °C erhitzt wird und/oder das Material in der zweiten Behandlungskammer auf Temperaturen von 1000°C bis 4000°C erhitzt wird.

12. Vorrichtung zur Durchführung eines Verfahrens nach einem der vorhergehenden Ansprüche, umfassend
∘ eine erste Behandlungskammer 1,
∘ eine zweite Behandlungskammer und
∘ einen Transferkanal 4, der die beiden Kammern miteinander verbindet,
wobei beide Behandlungskammern mit je wenigstens einer Heizvorrichtung 5, 6 versehen sind und ein Mittel 10 zur elektromagnetischen Beeinflussung der Fließgeschwindigkeit eines flüssigen, leitfähigen Materials im Transferkanal vorgesehen ist, wobei das Mittel 10 ein wanderndes elektromagnetisches Feld erzeugt, und der Fluss des flüssigen Materials verlangsamt und/oder gestoppt wird,
∘ wobei die erste Behandlungskammer 1 eine Wärmequelle 5, 6 umfasst, die ausgewählt ist aus Plasmabrenner und Elektronenstrahlkanone, und die zweite Behandlungskammer eine Elektronenstrahlkanone oder einen Plasmabrenner als Wärmequelle umfasst.

13. Vorrichtung nach Anspruch 12, wobei der Transferkanal 4 von der einen Behandlungskammer 1 in die andere Behandlungskammer ansteigt.

## Claims

1. A method for sequential treatment of a material, wherein
• a liquid material 3 is melted and refined at different pressures in different treatment chambers 1, wherein the separation between the pressure levels is realized by the liquid material itself so that a continuous process is possible,
• the liquid material is transferred from a first treatment chamber into another second treatment chamber, wherein the transfer of the material is achieved by pressure differences in combination with electromagnetic manipulation of the flow rate between the treatment chambers, and
• the heat sources used in the treatment chambers work independently from each other,
**characterized in that** the electromagnetic manipulation is realized by the use of means creating a travelling electromagnetic field, and that the manipulation comprises slowing-down and/or stopping of the flow of the liquid material,
and the pressure in the second treatment chamber is lower than in the first treatment chamber.

2. The method according to claim 1, **characterized in that** the transfer of the melt from the first treatment chamber into the second is realized in a channel 4 which may also be designed as a heated one.

3. The method according to claim 1 or 2, comprising the steps of:
• introducing the material 3 to be treated into the first treatment chamber 1,
• heat-treating the material in the first treatment chamber at a pressure of > 10 mbar so that the material takes on or retains a liquid state,
• transferring the liquid material into the second treatment chamber,
• heat-treating the liquid material in the second treatment chamber at a pressure of up to 10 mbar,
**characterized in that** the transfer of the liquid material from the first treatment chamber into the second treatment chamber is conducted by means of a transfer channel 4 which connects said both treatment chambers and allows a continuous flow of the liquid material.

4. The method according to at least one of the preceding claims, wherein the heat source in the second treatment chamber is an electron-beam gun.

5. The method according to at least one of the preceding claims, wherein the material to be treated comprises at least one metal, semimetal or one ceramic.

6. The method according to at least one of the preceding claims, wherein the material to be treated comprises silicon.

7. The method according to at least one of the preceding claims, wherein the electromagnetic manipulation of the flow rate in the transfer channel 4 is realized by the help of at least one coil 10 being arranged around the transfer channel.

8. The method according to at least one of the preceding claims, wherein the melt after the conducted treatment in the liquid state is subjected to a further treatment or in the liquid state it is fed into a separate facility for solidification and is solidified there.

9. The method according to at least one of the preceding claims, wherein the solidification of the melt after the treatment is realized as block withdrawal from an inductively heated, water-cooled copper crucible.

10. The method according to at least one of the preceding claims, wherein one heat source is a plasma burner and another heat source is an electron-beam gun, or both heat sources are electron-beam guns, or both heat sources are plasma burners, which work at different pressures.

11. The method according to at least one of the preceding claims, wherein the material in the first treatment chamber is heated to temperatures of 1000°C to 3000°C and/or the material in the second treatment chamber is heated to temperatures of 1000°C to 4000°C.

12. A device for conducting a method according to one of the preceding claims, comprising
• a first treatment chamber 1,
• a second treatment chamber and
• a transfer channel 4 which connects said both chambers with each other, wherein both treatment chambers are provided with at least one heating facility 5, 6 each and a means 10 for electromagnetic manipulation of the flow rate of a liquid, conductive material in the transfer channel is provided, wherein the means 10 creates a travelling electromagnetic field, and the flow of the liquid material is slowed down and/or stopped,
• wherein the first treatment chamber 1 comprises a heat source 5, 6 which is selected from a plasma burner and an electron-beam gun, and the second treatment chamber comprises an electron-beam gun or a plasma burner as a heat source.

13. The device according to claim 12, wherein the transfer channel 4 rises from said one treatment chamber 1 to said other treatment chamber.

## Revendications

1. Procédé servant au traitement séquentiel d'un matériau, dans lequel
- un matériau (3) liquide est fondu et raffiné dans différentes chambres de traitement (1) à des pressions différentes, dans lequel la délimitation des niveaux de pression est effectuée par le matériau liquide lui-même de sorte qu'un processus continu soit possible,
- le matériau liquide est transféré d'une première chambre de traitement dans une autre deuxième chambre de traitement, dans lequel le transfert du matériau est obtenu par des différences de pression en combinaison avec une influence électromagnétique de la vitesse d'écoulement entre les chambres de traitement, et
- les sources de chaleur employées dans les chambres de traitement fonctionnent indépendamment les unes des autres,
**caractérisé en ce que** l'influence électromagnétique est effectuée en utilisant des moyens, qui produisent un champ électromagnétique se déplaçant, et l'influence comprend un ralentissement et/ou un arrêt du flux du matériau liquide,
et la pression dans la deuxième chambre de traitement est inférieure à celle de la première chambre de traitement.

2. Procédé selon la revendication 1, **caractérisé en ce que** le transfert de la matière fondue de la première chambre de traitement dans la deuxième est effectué dans un canal (4), qui peut être réalisé également de manière chauffée.

3. Procédé selon la revendication 1 ou 2, comprenant les étapes consistant à :
- introduire le matériau (3) à traiter dans la première chambre de traitement (1) ;
- traiter à chaud le matériau dans la première chambre de traitement à une pression > 10 mbar de sorte que le matériau prenne ou conserve un état liquide ;
- transférer le matériau liquide dans la deuxième chambre de traitement ;
- traiter à chaud le matériau liquide dans la deuxième chambre de traitement à une pression pouvant aller jusqu'à 10 mbar ;
**caractérisé en ce que** le transfert du matériau liquide de la première chambre de traitement dans la deuxième chambre de traitement est réalisé au moyen d'un canal de transfert (4), qui relie les deux chambres de traitement et qui permet un écoulement continu du matériau liquide.

4. Procédé selon au moins l'une quelconque des revendications précédentes, dans lequel la source de chaleur dans la deuxième chambre de traitement est un canon à électrons.

5. Procédé selon au moins l'une quelconque des revendications précédentes, dans lequel le matériau à traiter comprend au moins un métal, un semi-métal ou une céramique.

6. Procédé selon au moins l'une quelconque des revendications précédentes, dans lequel le matériau à traiter comprend du silicium.

7. Procédé selon au moins l'une quelconque des revendications précédentes, dans lequel l'influence électromagnétique de la vitesse d'écoulement dans le canal de transfert (4) est effectuée à l'aide d'au moins une bobine (10) disposée dans le canal de transfert.

8. Procédé selon au moins l'une quelconque des revendications précédentes, dans lequel la matière fondue est amenée, après un traitement réalisé avec succès, dans l'état liquide à un autre traitement ou est amenée dans l'état liquide à un dispositif séparé de solidification et s'y solidifie.

9. Procédé selon au moins l'une quelconque des revendications précédentes, dans lequel la solidification de la matière fondue est effectuée après le traitement sous la forme d'un bloc prélevé provenant d'un creuset en cuivre chauffé de manière inductive, refroidi à l'eau.

10. Procédé selon au moins l'une quelconque des revendications précédentes, dans lequel une source de chaleur est une torche à plasma et une autre source de chaleur est un canon à électrons, ou les deux sources de chaleur sont des canons à électrons ou les deux sources de chaleur sont des torches à plasma, qui fonctionnent à des pressions différentes.

11. Procédé selon au moins l'une quelconque des revendications précédentes, dans lequel le matériau est chauffé dans la première chambre de traitement à des températures allant de 1 000 °C à 3 000 °C, et/ou le matériau est chauffé dans la deuxième chambre de traitement à des températures allant de 1 000 °C à 4 000 °C.

12. Dispositif servant à réaliser un procédé selon l'une quelconque des revendications précédentes, comprenant
- une première chambre de traitement (1),
- une deuxième chambre de traitement et
- un canal de transfert (4), qui relie entre elles les deux chambres,
dans lequel les deux chambres de traitement sont pourvues respectivement d'au moins un dispositif de chauffage (5, 6) et un moyen (10) servant à influencer de manière électromagnétique la vitesse d'écoulement d'un matériau liquide, conducteur est prévu dans le canal de transfert, dans lequel le moyen (10) produit un champ électromagnétique se déplaçant, et le flux du matériau liquide est ralenti et/ou arrêté,
- dans lequel la première chambre de traitement (1) comprend une source de chaleur (5, 6), qui est choisie parmi une torche à plasma et un canon à électrons, et la deuxième chambre de traitement comprend en tant que source de chaleur un canon à électrons ou une torche à plasma.

13. Dispositif selon la revendication 12, dans lequel le canal de transfert (4) augmente d'une chambre de traitement (1) dans l'autre chambre de traitement.
